(19) Europäisches Patentamt / European Patent Office / Office européen des brevets

(11) **EP 3 187 842 B1**

(12) **FASCICULE DE BREVET EUROPEEN**

(45) Date de publication et mention de la délivrance du brevet:
**05.09.2018 Bulletin 2018/36**

(51) Int Cl.:
**G01R 31/12** *(2006.01)*  **H02H 1/00** *(2006.01)*
**G01H 1/00** *(2006.01)*  **G01H 17/00** *(2006.01)*

(21) Numéro de dépôt: **16206506.4**

(22) Date de dépôt: **22.12.2016**

(54) **PROCÉDÉ POUR DÉTECTER UN ARC ÉLECTRIQUE PAR ANALYSE DE SA SIGNATURE ACOUSTIQUE**

VERFAHREN ZUR DETEKTION EINES LICHTBOGENS DURCH ANALYSE SEINER AKUSTISCHEN SIGNATUR

METHOD FOR DETECTING AN ELECTRIC ARC BY ANALYSING THE ACOUSTIC SIGNATURE THEREOF

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.12.2015 FR 1563381**

(43) Date de publication de la demande:
**05.07.2017 Bulletin 2017/27**

(73) Titulaires:
• **COMMISSARIAT À L'ÉNERGIE ATOMIQUE ET AUX ÉNERGIES ALTERNATIVES**
**75015 Paris (FR)**
• **Safran Electrical & Power**
**31700 Blagnac (FR)**

(72) Inventeurs:
• **ALBERTO, Diego**
**38600 FONTAINE (FR)**
• **HEIRIES, Vincent**
**38430 SAINT-JEAN DE MOIRANS (FR)**
• **PERICHON, Pierre**
**38500 VOIRON (FR)**
• **GENOULAZ, Jérôme**
**31700 BLAGNAC (FR)**

(74) Mandataire: **Cabinet Beaumont**
**4, Place Robert Schuman**
**B.P. 1529**
**38025 Grenoble Cedex 1 (FR)**

(56) Documents cités:
• **SWEDAN A ET AL: "Enhancement of acoustic based partial discharge detection using pattern recognition techniques", ELECTRIC POWER AND ENERGY CONVERSION SYSTEMS (EPECS), 2011 2ND INTERNATIONAL CONFERENCE ON, IEEE, 15 novembre 2011 (2011-11-15), pages 1-4, XP032093987, DOI: 10.1109/EPECS.2011.6126812 ISBN: 978-1-4577-0804-6**
• **KUNDU P ET AL: "Frequency domain analysis of acoustic emission signals for classification of partial discharges", ELECTRICAL INSULATION AND DIELECTRIC PHENOMENA, 2007. CEIDP 2007. ANNUAL REPORT - CONFERENCE ON, IEEE, PISCATAWAY, NJ, USA, 14 octobre 2007 (2007-10-14), pages 146-149, XP031230509, ISBN: 978-1-4244-1481-9**
• **TOMASZ BOCZAR ET AL: "The Application of Modern Signal Processing Methods in the Acoustic Emission Method for the Measurement of Insulation Systems of Power Transformers", EUROPEAN CONFERENCE ON NON DESTRUCTIVE TESTING, 25 septembre 2006 (2006-09-25), XP055313627,**

**Description**

Domaine

La présente demande concerne un procédé pour détecter la formation d'un arc électrique dans un système électrique à partir de sa signature acoustique.

Exposé de l'art antérieur

Dans de nombreux systèmes électriques, notamment des systèmes haute tension tels que des armoires électriques, des transformateurs, des batteries électriques, des réseaux de distribution électrique, etc., des arcs électriques peuvent se former, par exemple par suite d'une surtension ou d'une défaillance telle que la rupture d'un câble ou l'usure d'un isolant. S'il est entretenu, un arc électrique peut provoquer de graves dommages et notamment entrainer un départ de feu. Les arcs électriques sont tout particulièrement dangereux dans les systèmes électriques à alimentation continue, dans la mesure où l'on ne peut pas compter sur un passage à zéro "naturel" de la tension d'alimentation pour provoquer l'extinction de l'arc. La détection précoce de la formation d'un arc électrique est un enjeu majeur pour la sécurité de nombreux systèmes électriques.

Diverses solutions ont été proposées pour détecter la formation d'un arc électrique dans un système électrique. On a notamment proposé des méthodes de détection basées sur des mesures de courant et de tension dans le système, des méthodes de détection basées sur des mesures de signaux optiques, des méthodes de détection basées sur des mesures de signaux électromagnétiques, et des méthodes de détection basées sur des mesures de signaux acoustiques. Le document : A Swedanm A.H. El-Hag and K. Assaleh (2011), intitulé "Enhancement of Acoustic Based Partial Discharge Détection Using Pattern Récognition Techniques" divulgue une comparaison de différentes méthodes d'analyse de signaux acoustiques, dans le but de détecter la formation d'un arc électrique dans un système électrique. On s'intéresse ici plus particulièrement aux méthodes de détection basées sur des mesures de signaux acoustiques.

Résumé

Ainsi, un mode de réalisation prévoit un procédé pour détecter un arc électrique dans un système électrique à partir d'un signal provenant d'au moins un capteur détectant des ondes acoustiques dans le système, comprenant : a) calculer au moyen d'un dispositif de traitement, sur une fenêtre glissante d'échantillons du signal, au moins un paramètre statistique choisi parmi le coefficient de dissymétrie et le coefficient d'aplatissement du signal ; b) détecter une occurrence éventuelle d'un évènement en tenant compte dudit au moins un paramètre statistique ; et c) réaliser une analyse fréquentielle du signal permettant d'identifier un arc électrique lorsqu'un évènement est détecté à l'étape b).

Selon un mode de réalisation, l'étape b) comprend la détection d'un pic ou d'une variation d'amplitude caractéristique dudit au moins un paramètre statistique.

Selon un mode de réalisation, le procédé comprend en outre le calcul d'une grandeur représentative de l'énergie instantanée du signal.

Selon un mode de réalisation, à l'étape b), il est tenu compte de ladite grandeur représentative de l'énergie instantanée du signal pour détecter une occurrence éventuelle d'un événement.

Selon un mode de réalisation, l'étape c) comprend le calcul de la dérivée d'ordre 3 du signal, et la recherche d'un pic caractéristique dans le signal dérivé.

Selon un mode de réalisation, l'étape c) comprend le calcul de la densité spectrale de puissance du signal.

Selon un mode de réalisation, l'étape c) comprend le calcul d'une grandeur représentative de l'énergie du signal dans une bande spectrale caractéristique des arcs électriques, et la détection du franchissement éventuel d'un seuil d'énergie dans cette bande.

Selon un mode de réalisation, la grandeur représentative de l'énergie du signal dans une bande spectrale caractéristique des arcs électriques est normalisée par rapport à une grandeur représentative de l'énergie du signal dans une autre bande spectrale.

Un autre mode de réalisation prévoit un dispositif de calcul pour détecter un arc électrique dans un système électrique à partir d'un signal provenant d'au moins un capteur détectant des ondes acoustiques dans le système, comprenant un dispositif de traitement agencé pour : a) calculer au moyen d'un dispositif de traitement, sur une fenêtre glissante d'échantillons du signal, au moins un paramètre statistique choisi parmi le coefficient de dissymétrie et le coefficient d'aplatissement du signal ; b) détecter une occurrence éventuelle d'un évènement en tenant compte dudit au moins un paramètre statistique ; et c) réaliser une analyse fréquentielle du signal permettant d'identifier un arc électrique lorsqu'un évènement est détecté à l'étape b).

Un autre mode de réalisation prévoit un système comprenant : un système électrique ; au moins un capteur agencé pour détecter des ondes acoustiques dans le système électrique ; et un dispositif de calcul tel que défini ci-dessus agencé pour traiter un signal de sortie du capteur.

Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :

la figure 1 illustre un système électrique muni d'un dispositif de détection d'un arc électrique selon un exemple d'un mode de réalisation ;
la figure 2 est un organigramme illustrant des étapes d'un procédé de détection d'un arc électrique selon un exemple d'un mode de réalisation ; et
la figure 3 illustre un dispositif adapté à la mise en oeuvre d'un procédé de détection d'un arc électrique selon un exemple d'un mode de réalisation.

Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. En particulier, les systèmes électriques dans lesquels on cherche à détecter des arcs électriques n'ont pas été détaillés, les solutions de détection décrites étant compatibles avec tous les systèmes électriques dans lesquels peuvent se produire des arcs électriques.

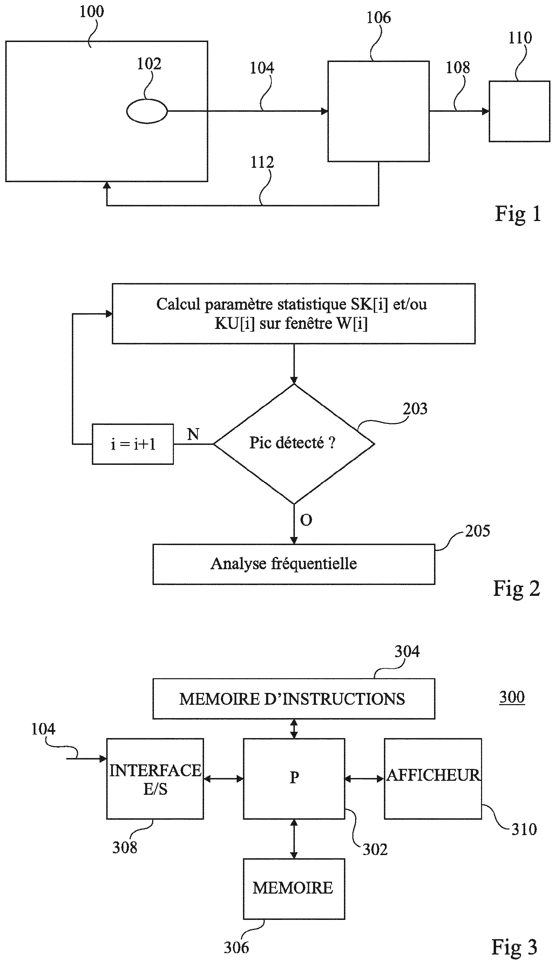

La figure 1 représente un système électrique 100 à surveiller, par exemple une armoire électrique, un réseau de distribution d'électricité dans un avion, une batterie électrique, ou tout autre système électrique dans lequel on souhaite pouvoir détecter l'apparition éventuelle d'un arc électrique.

Le système électrique 100 est équipé d'un dispositif de détection d'un arc électrique comportant un capteur acoustique 102, par exemple un capteur à ultrasons, adapté à détecter des ondes acoustiques dans le système électrique 100. La formation d'un arc électrique s'accompagne en effet de l'émission d'ondes acoustiques caractéristiques dont la détection peut permettre d'identifier la présence de l'arc. Le capteur 102 peut être disposé sur une paroi d'un boîtier du système électrique 100, ou en contact physique avec un conducteur électrique que l'on souhaite surveiller tout particulièrement. Bien qu'un seul capteur 102 soit illustré en figure 1, dans des variantes de réalisation, plusieurs capteurs 102 peuvent être prévus pour surveiller différentes parties du système 100. La sortie de chaque capteur 102 est par exemple traitée séparément de façon similaire ou identique à ce qui va être décrit plus en détail ci-après.

Le capteur 102 fournit un signal de sortie 104 à un dispositif de calcul 106 du dispositif de détection d'un arc électrique. A titre d'exemple, le signal de sortie 104 du capteur 102 est un signal numérique, et le dispositif de calcul 106 est un circuit de traitement numérique comprenant par exemple un microprocesseur. Le signal de sortie 104 est un signal dans le domaine temporel, représentant l'évolution en fonction du temps de l'amplitude des ondes acoustiques captées par le capteur 102. Le dispositif de calcul 106 est adapté à analyser le signal fourni par le capteur 102 pour détecter la présence éventuelle d'un arc électrique dans le système 100.

Le dispositif de calcul 106 fournit par exemple un signal de sortie 108 à un module de sortie 110 du dispositif de détection d'un arc électrique, qui peut être une alarme, un afficheur, ou tout autre élément d'interface permettant d'informer un utilisateur de la présence d'un arc dans le système 100.

Le dispositif de calcul 106 peut fournir, en plus ou à la place du signal de sortie 108, un signal de sortie 112 renvoyé vers le système 100, qui peut par exemple commander la mise en sécurité du système 100 lorsqu'un arc électrique est détecté, par exemple par interruption du courant d'alimentation dans tout ou partie du système 100.

La mise en oeuvre d'une détection robuste d'un arc électrique à partir de sa signature acoustique passe par une analyse fréquentielle des signaux acoustiques détectés par le capteur 102. En effet, la détection de pics d'énergie acoustique dans des bandes de fréquence particulières, par exemple entre 80 et 120 kHz, permet d'obtenir de bonnes performances de détection des arcs électriques et de minimiser les risques de fausse détection liés à d'autres phénomènes susceptibles de générer des signaux acoustiques, par exemple des chocs mécaniques. L'analyse fréquentielle en temps réel du signal de sortie du capteur 102 requiert toutefois des ressources calculatoires importantes, et se traduit par une consommation électrique élevée du dispositif de calcul 106.

La figure 2 est un organigramme illustrant des étapes d'un procédé de détection d'un arc électrique selon un exemple d'un mode de réalisation. Ce procédé peut être mis en oeuvre par le dispositif de calcul 106 du dispositif de détection d'arc électrique de la figure 1 pour réaliser une surveillance continue du système 100 et détecter au plus vite la formation d'un arc électrique. Un avantage du procédé de la figure 2 réside dans sa complexité calculatoire relativement faible, qui permet notamment de limiter la consommation électrique du dispositif de calcul 106.

Le procédé de la figure 2 comprend une étape 201 de calcul, sur une fenêtre W[i] d'échantillons consécutifs du signal de sortie 104 du capteur 102, d'au moins l'un des paramètres statistiques suivants du signal 104 : le coefficient de dissymétrie (souvent désigné par le terme anglo-saxon "skewness") ; et le coefficient d'aplatissement (aussi appelé kurtosis).

Le coefficient de dissymétrie SK[i] et le coefficient d'aplatissement KU[i] du signal 104 dans la fenêtre W[i] peuvent être définis comme suit :

$$SK[i] = \sum_{j=1}^{n} \frac{(y_j - \bar{y})^3 / n}{s^3}$$

$$KU[i] = \sum_{j=1}^{n} \frac{(y_j - \bar{y})^4 / n}{s^4}$$

où n est le nombre d'échantillons de la fenêtre W[i], j est un entier allant de 1 à n, $y_j$ est la valeur de l'échantillon de rang j de la fenêtre W[i], $\bar{y}$ est la moyenne des n échantillons $y_j$ de la fenêtre W[i] et s est l'écart type des n échantillons $y_j$ de la fenêtre W[i].

La fenêtre W[i] est une fenêtre glissante, et le calcul des paramètres statistiques SK[i] et/ou KU[i] peut être réalisé en temps réel au fur et à mesure de l'arrivée des échantillons. A titre d'exemple illustratif, la fenêtre W[i] comprend n=2000 échantillons et la période d'échantillonnage du signal 104 est égale à 1 µs, de sorte que chaque fenêtre W[i] couvre une période de 2 ms. Le pas de glissement de la fenêtre est par exemple de 1 échantillon, c'est-à-dire que la fenêtre W[i+1] contient les n-1 derniers échantillons $y_j$ de la fenêtre W[i], plus un échantillon supplémentaire consécutif au dernier échantillon $y_n$ de la fenêtre W[i] .

Les inventeurs ont constaté que la formation d'un arc électrique dans le système 100 se traduit par l'apparition d'un pic ou d'une forte variation d'amplitude dans l'un et/ou l'autre des signaux statistiques SK[i] et KU[i].

Ainsi, le procédé de la figure 2 comprend une étape 203 de détection d'un pic ou d'une forte variation d'amplitude dans le signal statistique SK[i] et/ou KU[i]. A titre d'exemple, l'étape 203 peut comprendre, après l'étape de calcul du paramètre statistique SK[i] et/ou KU[i], une étape de détection du franchissement éventuel d'un seuil haut ou bas par le paramètre statistique SK[i] et/ou KU[i].

Si aucun pic et aucune variation significative d'amplitude ne sont détectés à l'étape 203, les étapes 201 et 203 sont à nouveau mises en oeuvre pour la fenêtre suivante W[i+1] du signal 104.

Si un pic ou une forte variation d'amplitude du paramètre statistique SK[i] et/ou KU[i] sont détectés à l'étape 203, le dispositif de détection peut en déduire qu'un évènement pouvant correspondre à la formation d'un arc électrique s'est produit dans le système 100. La seule analyse statistique du signal 104 ne permet toutefois pas de déterminer avec certitude que l'événement détecté correspond à l'apparition d'un arc électrique. En effet, d'autres évènements tels qu'un choc mécanique peuvent être à l'origine du pic détecté dans le signal SK[i] et/ou KU[i]. Ainsi, lorsqu'un évènement pouvant correspondre à un arc électrique est détecté à partir du signal statistique SK[i] et/ou KU[i] à l'étape 203, le procédé de la figure 2 met en oeuvre, lors d'une étape 205, une analyse fréquentielle du signal 104, permettant de discriminer la formation d'un arc électrique parmi différents types d'événements. Des exemples de méthodes d'analyse fréquentielle du signal 104 pouvant être mises en oeuvre à l'étape 205 seront décrites ci-après.

Lorsqu'un arc électrique est détecté lors de l'étape d'analyse fréquentielle 205, un signal de sortie signalant cette détection peut être généré, par exemple en vue de déclencher une alarme et/ou une mise en sécurité du système électrique 100.

Un avantage du procédé de la figure 2 est qu'en l'absence d'événement remarquable dans le système 100, sa complexité calculatoire se limite à la mise en oeuvre d'un calcul d'un ou plusieurs paramètres statistiques du signal 104 dans le domaine temporel. Ce n'est que lorsqu'un évènement remarquable est détecté à partir de cette analyse statistique du signal 104, qu'une analyse fréquentielle (potentiellement plus lourde en calculs) est mise en oeuvre pour permettre de discriminer plus finement un arc électrique parmi différents types d'événements et limiter ainsi les risques de fausses détections. Cette approche permet de réduire la consommation électrique globale du dispositif de détection d'arc électrique.

On notera qu'à l'étape 203, la détection d'un évènement peut être réalisée à partir du seul paramètre SK[i], à partir du seul paramètre KU[i], ou à partir des deux paramètres SK[i] et KU[i]. A titre d'exemple, la mise en oeuvre d'une analyse fréquentielle du signal 104 peut être déclenchée lorsqu'un pic ou une variation significative d'amplitude sont détectés dans le signal SK[i], ou lorsqu'un pic ou une variation significative d'amplitude sont détectés dans le signal KU[i], ou lorsqu'un pic ou une variation significative d'amplitude sont détectés dans le signal produit SK[i]*KU[i].

Outre les paramètres statistiques SK[i] et/ou KU[i], la détection d'un évènement pouvant correspondre à un arc électrique peut se baser sur d'autres grandeurs caractéristiques du signal 104, par exemple sur l'énergie instantanée du signal 104. A titre d'exemple, l'étape 201 peut en outre comprendre, pour chaque échantillon du signal 104, le calcul de l'énergie instantanée du signal 104 normalisée sur l'écart type du bruit acoustique, définie comme suit :

$$EIN[i] = \frac{|y_i - \mu_{noise}|}{\sigma_{noise}}$$

où $\sigma_{noise}$ est l'écart type du bruit acoustique mesuré par le capteur 102 sur une fenêtre de référence en l'absence de tout évènement remarquable (arc électrique, choc mécanique, etc.) susceptible de générer des ondes acoustiques, et où $\mu_{noise}$ est la moyenne du bruit acoustique dans cette même fenêtre de référence.

Lors de l'étape 203, on peut alors par exemple considérer qu'un évènement remarquable pouvant correspondre à un arc électrique s'est produit, et décider en conséquence de mettre en oeuvre l'étape 205 d'analyse fréquentielle du signal 104, lorsqu'un pic ou une variation significative d'amplitude ont été détectés dans le signal statistique SK[i] et/ou KU[i], et que l'énergie instantanée normalisée EIN[i] de l'échantillon courant est supérieure à un seuil S. Le seuil S est par exemple compris entre $4*\sigma_{noise}$ et $6*\sigma_{noise}$, par exemple égal à $5*\sigma_{noise}$.

### Analyse fréquentielle - premier exemple

Dans cet exemple, l'étape 205 comprend le calcul de la dérivée d'ordre 3 du signal 104. L'opération de dérivation à l'ordre 3 du signal 104 correspond à un filtrage passe-haut du signal 104. Cette opération offre un bon compromis entre complexité calculatoire et efficacité de détection/discrimination des arcs électriques. La dérivée d'ordre 3 du signal 104 présente un pic remarquable en présence d'un arc électrique, et ne présente aucun pic en présence d'un choc mécanique. Ainsi, l'étape 205 peut comprendre la recherche d'un éventuel pic caractéristique d'un arc électrique dans le signal 104. A titre d'exemple, le calcul de la dérivée d'ordre 3 du signal 104 et la recherche d'un éventuel pic dans le signal dérivé peuvent être mis en oeuvre sur la même fenêtre W[i] d'échantillons du signal 104 que celle ayant conduit à détecter un évènement remarquable à l'étape 203, et/ou sur les fenêtres suivantes. Les modes de réalisation décrits ne se limitent toutefois pas à ce cas particulier.

### Analyse fréquentielle - deuxième exemple

Dans cet exemple, l'étape 205 comprend une conversion du signal temporel 104 fourni par le capteur 102 dans le domaine fréquentiel. Pour cela, l'étape 205 comprend par exemple le calcul d'une transformée de Fourier locale ou STFT (en anglais "Short Time Fourier Transform") sur une fenêtre d'échantillons consécutifs du signal 104, par exemple la même fenêtre W[i] d'échantillons du signal 104 que celle ayant conduit à détecter un évènement remarquable à l'étape 203. La densité spectrale de puissance ou DSP dans la fenêtre de traitement peut ensuite être estimée, par exemple en calculant le module au carré de la STFT normalisé sur l'énergie totale de la fenêtre traitée. Connaissant la ou les bandes de fréquence des ondes acoustiques générées par un arc électrique, il est alors possible de détecter/discriminer efficacement un arc électrique parmi différents types d'événements. A titre d'exemple, l'étape 205 peut comprendre le calcul de l'énergie du signal 104 dans une bande spectrale caractéristique des arcs électriques, par exemple la bande allant de 80 à 120 kHz, et la détection du franchissement éventuel d'un seuil d'énergie dans cette bande. Le traitement spectral du signal 104 peut être poursuivi en faisant glisser la fenêtre de traitement de manière à construire le spectrogramme du signal 104, c'est-à-dire une matrice dans laquelle chaque colonne contient la DSP du signal 104 pour une fenêtre temporelle d'échantillons du signal 104. Le calcul du spectrogramme permet de suivre l'évolution temporelle du spectre du signal 104, ce qui permet d'améliorer encore les performances de détection/discrimination des arcs électriques. L'étape 205 peut notamment comprendre l'analyse de l'évolution temporelle de l'énergie du signal 104 dans une ou plusieurs bandes spectrales spécifiques. Cette analyse peut être réalisée de façon différentielle, par exemple en comparant l'énergie du signal 104 dans une bande spectrale caractéristique des arcs électriques à l'énergie du signal 104 dans une ou plusieurs autres bandes spectrales.

La STFT calculée à l'étape 205 peut être définie comme suit :

$$STFT\{x[n]\}(m,\omega) = X[m,\omega] = \sum_{n=-\infty}^{+\infty} x[n] - wind[n-m].e^{-j\omega n}$$

où X[m,ω] est la STFT, m et ω sont les variables discrétisées en temps (m) et en fréquence (ω) de la STFT, x[n] est le signal dans le temps, n est le temps discret, et wind[] est la fenêtre glissante utilisée pour choisir et pondérer le sous-ensemble des échantillons sur lequel est estimée la STFT.

Pour un temps m fixé, la DSP calculée à l'étape 205 peut être définie comme suit :

$$P_{X,norm}(\omega) = \frac{|X[\omega]|^2}{\sum_{\omega=0}^{\omega s/2} |X[\omega]|^2}$$

où X[ω] est la STFT pour un temps m fixé, et où la somme au dénominateur correspond à l'énergie totale du signal contenu dans la fenêtre de calcul dans la bande allant de 0 à ωs/2, avec ωs=2πfs, fs étant la fréquence d'échantillonnage du signal 104.

La figure 3 illustre un exemple d'un dispositif de traitement 300 du dispositif de calcul 106 de la figure 1. Le dispositif de traitement 300 est agencé pour mettre en oeuvre le procédé de détection d'arc électrique décrit ci-dessus. Le dispositif 300 peut comprendre un ou plusieurs processeurs 302 (P) recevant des instructions mémorisées dans une mémoire d'instructions 304. Le dispositif de traitement 300 peut en outre comporter une mémoire 306 configurée pour mémoriser les différentes grandeurs calculées lors de la mise en oeuvre du procédé de détection d'arc électrique, par exemple les paramètres statistiques SK[i] et/ou KU[i], l'énergie instantanée EIN[i] le cas échéant, la dérivée d'ordre 3 du signal 104 le cas échéant, les STFT et les DSP du signal 104 le cas échéant, etc. La mémoire 306 peut en outre mémoriser le signal variable dans le temps 104 provenant du capteur 102, qui est par exemple reçu par le processeur 302 par l'intermédiaire d'une interface d'entrée / sortie 308. L'interface d'entrée/sortie 308 peut en outre fournir le signal de sortie 112 du dispositif 106 adapté à contrôler le fonctionnement du système électrique 100 dans le cas où un arc électrique est détecté. Le dispositif de traitement 300 comprend par exemple en plus un afficheur 310, qui par exemple fournit une interface utilisateur et des moyens pour alerter un utilisateur si un arc électrique est détecté.

Des modes de réalisation particuliers ont été décrits. Diverses variantes et modifications apparaîtront à l'homme de l'art. En particulier, les modes de réalisation décrits ne se limitent pas aux exemples de méthodes d'analyse fréquentielle du signal 104 (étape 205 du procédé de la figure 2) décrites ci-dessus. Plus généralement, toute autre méthode d'analyse fréquentielle permettant la détection d'un arc électrique à partir de sa signature acoustique peut être mise en oeuvre lors de l'étape 205 du procédé de la figure 2.

En outre, le procédé de détection d'arc électrique décrit en relation avec la figure 2 peut comprendre des étapes supplémentaires optionnelles pour améliorer ses performances. A titre d'exemple un prétraitement du signal 104 peut être mis en oeuvre, consistant à réaliser un filtrage passe-bande du signal, selon une bande passante incluant les fréquences d'émission typiques des arcs électriques et des chocs mécaniques, de façon à réduire la contribution énergétique du bruit. On notera que l'inclusion dans la bande passante du filtre de prétraitement des fréquences caractéristiques des chocs mécaniques (en plus des fréquences caractéristiques des arcs électriques) est facultative, mais a pour avantage de permettre la mise en oeuvre d'une détection d'arc par analyse différentielle (différence entre l'énergie aux fréquences caractéristiques des arcs et l'énergie aux fréquences caractéristiques des chocs).

## Revendications

1. Procédé pour détecter un arc électrique dans un système électrique (100) à partir d'un signal (104) provenant d'au moins un capteur (102) détectant des ondes acoustiques dans le système, comprenant :

   a) calculer au moyen d'un dispositif de traitement, sur une fenêtre glissante (W[i]) d'échantillons du signal (104), au moins un paramètre statistique choisi parmi le coefficient de dissymétrie (SK[i]) et le coefficient d'aplatissement (KU[i]) du signal (104) ;
   b) détecter une occurrence éventuelle d'un évènement en tenant compte dudit au moins un paramètre statistique (SK[i], KU[i]) ; et
   c) réaliser une analyse fréquentielle du signal (104) permettant d'identifier un arc électrique lorsqu'un évènement est détecté à l'étape b).

**2.** Procédé selon la revendication 1, dans lequel l'étape b) comprend la détection d'un pic ou d'une variation d'amplitude caractéristique dudit au moins un paramètre statistique (SK[i], KU[i]).

**3.** Procédé selon la revendication 1 ou 2, comprenant en outre le calcul d'une grandeur représentative de l'énergie instantanée du signal (104).

**4.** Procédé selon la revendication 3, dans lequel, à l'étape b), il est tenu compte de ladite grandeur représentative de l'énergie instantanée du signal (104) pour détecter une occurrence éventuelle d'un événement.

**5.** Procédé selon l'une quelconque des revendications 1 à 4, dans lequel l'étape c) comprend le calcul de la dérivée d'ordre 3 du signal (104), et la recherche d'un pic caractéristique dans le signal dérivé.

**6.** Procédé selon l'une quelconque des revendications 1 à 4, dans lequel l'étape c) comprend le calcul de la densité spectrale de puissance du signal (104).

**7.** Procédé selon la revendication 6, dans lequel l'étape c) comprend le calcul d'une grandeur représentative de l'énergie du signal (104) dans une bande spectrale caractéristique des arcs électriques, et la détection du franchissement éventuel d'un seuil d'énergie dans cette bande.

**8.** Procédé selon la revendication 7, dans lequel ladite grandeur représentative de l'énergie du signal (104) dans une bande spectrale caractéristique des arcs électriques est normalisée par rapport à une grandeur représentative de l'énergie du signal (104) dans une autre bande spectrale.

**9.** Dispositif de calcul (106) pour détecter un arc électrique dans un système électrique (100) à partir d'un signal (104) provenant d'au moins un capteur (102) détectant des ondes acoustiques dans le système, comprenant un dispositif de traitement agencé pour :

a) calculer au moyen d'un dispositif de traitement, sur une fenêtre glissante (W[i]) d'échantillons du signal (104), au moins un paramètre statistique choisi parmi le coefficient de dissymétrie (SK[i]) et le coefficient d'aplatissement (KU[i]) du signal (104) ;
b) détecter une occurrence éventuelle d'un évènement en tenant compte dudit au moins un paramètre statistique (SK[i], KU[i]) ; et
c) réaliser une analyse fréquentielle du signal (104) permettant d'identifier un arc électrique lorsqu'un évènement est détecté à l'étape b).

**10.** Système comprenant :

un système électrique (100) ;
au moins un capteur (102) agencé pour détecter des ondes acoustiques dans le système électrique (100) ; et
un dispositif de calcul (106) selon la revendication 9 agencé pour traiter un signal de sortie (104) dudit au moins un capteur (102).

**Patentansprüche**

**1.** Verfahren zum Detektieren eines Lichtbogens in einem elektrischen System (100) von einem Signal (104), das von wenigstens einem Sensor (102) stammt, der akustische Wellen in dem System detektiert, das Folgendes aufweist:

a) Berechnen mittels einer Verarbeitungsvorrichtung von Signalabtastungen (104) über ein Gleitfenster (W[i]) von wenigstens einem statistischen Parameter, ausgewählt aus der Abweichungen (SK[i]) und der Kurtosis (KU[i]) des Signals (104).
b) Detektieren eines möglichen Auftretens eines Ereignisses unter Berücksichtigung des wenigstens einen statistischen Parameters (SK[i]), KU[i]); und
c) Durchführen einer Frequenzanalyse des Signals (104) zum Ermöglichen des Identifizierens eines Lichtbogens, wenn ein Ereignis in Schritt b) detektiert wird.

**2.** Verfahren nach Anspruch 1, wobei Schritt b) das Detektieren einer Spitze oder einer Amplitudenvariation aufweist, die charakteristisch für die wenigstens einen statistischen Parameter (SK[i]), KU[i]) ist.

**EP 3 187 842 B1**

**3.** Verfahren nach Anspruch 1 oder 2, das ferner das Berechnen einer Größe, welche die Momentanenergie des Signals (104) repräsentiert, aufweist.

**4.** Verfahren nach Anspruch 3, wobei im Schritt b) die Größe, welche die Momentanenergie des Signals (104) repräsentiert, beim Detektieren eines möglichen Auftretens eines Ereignisses berücksichtigt wird.

**5.** Verfahren nach einem der Ansprüche 1 bis 4, wobei Schritt c) das Berechnen der Ableitung dritter Ordnung des Signals (104) aufweist, und das Suchen einer charakteristischen Spitze in dem abgeleiteten Signal.

**6.** Verfahren nach einem der Ansprüche 1 bis 4, wobei Schritt c) das Berechnen der spektralen Leistungsdichte des Signals (104) aufweist.

**7.** Verfahren nach Anspruch 6, wobei Schritt c) das Berechnen der Größe, welche die Energie des Signals (104) in einem für Lichtbögen charakteristischen Spektralband repräsentiert, und das Detektieren der möglichen Überschreitung eines Energieschwellenwertes in diesem Band aufweist.

**8.** Verfahren nach Anspruch 7, wobei die Größe, welche die Energie des Signals (104) in einem für Lichtbögen charakteristischen Spektralband repräsentiert, bezüglich einer Größe, welche die Energie des Signals (104) in einem anderen Spektralband repräsentiert, normalisiert wird.

**9.** Eine Berechnungsvorrichtung (106) zum Detektieren eines Lichtbogens in einem elektrischen System (100) von einem Signal (104), das von wenigstens einem Sensor (102) stammt, der akustische Wellen in dem System detektiert, das eine Verarbeitungsvorrichtung aufweist, die angeordnet ist zum:

a) Berechnen mittels einer Verarbeitungsvorrichtung von Signalabtastungen (104) über ein Gleitfenster (W[i]) von wenigstens einem statistischen Parameter, ausgewählt aus der Abweichungen (SK[i]) und der Kurtosis (KU[i]) des Signals (104).
b) Detektieren eines möglichen Auftretens eines Ereignisses unter Berücksichtigung des wenigstens einen statistischen Parameters (SK[i]), KU[i]); und
c) Durchführen einer Frequenzanalyse des Signals (104) zum Ermöglichen des Identifizierens eines Lichtbogens, wenn ein Ereignis in Schritt b) detektiert wird.

**10.** Ein System, das Folgendes aufweist:

ein elektrisches System (100);
wenigstens einen Sensor (102) angeordnet zum Detektieren akustischer Wellen in dem elektrischen System (100); und
die Berechnungsvorrichtung (106) nach Anspruch 9, angeordnet zum Verarbeiten eines Ausgangssignals (104) des wenigstens einen Sensors (102).

**Claims**

**1.** A method of detecting an electric arc in an electrical system (100) from a signal (104) originating from at least one sensor (102) detecting acoustic waves in the system, comprising:

a) calculating by means of a processing device, over a sliding window (W[i]) of samples of the signal (104), at least one statistical parameter selected from the skewness (SK[i]) and the kurtosis (KU[i]) of the signal (104);
b) detecting a possible occurrence of an event by taking into account said at least one statistical parameter (SK[i], KU[i]); and
c) performing a frequency analysis of the signal (104) enabling to identify an electric arc when an event is detected at step b).

**2.** The method of claim 1, wherein step b) comprises detecting a peak or an amplitude variation characteristic of said at least one statistical parameter (SK[i], KU[i]).

**3.** The method of claim 1 or 2, further comprising calculating a quantity representative of the instantaneous energy of the signal (104).

8

4. The method of claim 3, wherein, at step b), said quantity representative of the instantaneous energy of the signal (104) is taken into account to detect a possible occurrence of an event.

5. The method of any of claims 1 to 4, wherein step c) comprises calculating the 3$^{rd}$-order derivative of the signal (104), and searching for a characteristic peak in the derived signal.

6. The method of any of claims 1 to 4, wherein step c) comprises calculating the spectral power density of the signal (104) .

7. The method of claim 6, wherein step c) comprises calculating a quantity representative of the energy of the signal (104) in a spectral band characteristic of electric arcs, and detecting the possible crossing of an energy threshold in this band.

8. The method of claim 7, wherein said quantity representative of the energy of the signal (104) in a spectral band characteristic of electric arcs is normalized with respect to a quantity representative of the energy of the signal (104) in another spectral band.

9. A calculation device (106) for detecting an electric arc in an electrical system (100) from a signal (104) originating from at least one sensor (102) detecting acoustic waves in the system, comprising a processing device arranged to:

a) calculate by means of a processing device, over a sliding window (W[i]) of samples of the signal (104), at least one statistical parameter selected from the skewness (SK[i]) and the kurtosis (KU[i]) of the signal (104);
b) detect a possible occurrence of an event by taking into account said at least one statistical parameter (SK[i], KU[i]); and
c) perform a frequency analysis of the signal (104) enabling to identify an electric arc when an event is detected at step b).

10. A system comprising:

an electrical system (100);
at least one sensor (102) arranged to detect acoustic waves in the electrical system (100); and
the calculation device (106) of claim 9, arranged to process an output signal (104) of said at least one sensor (102).

Fig 1

Calcul paramètre statistique SK[i] et/ou
KU[i] sur fenêtre W[i]

203

i = i+1    N    Pic détecté ?

O

Analyse fréquentielle    205

Fig 2

304

MEMOIRE D'INSTRUCTIONS    300

104

INTERFACE
E/S    P    AFFICHEUR

308    302    310

MEMOIRE

306    Fig 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **A SWEDANM A.H. EL-HAG ; K. ASSALEH.** *Enhancement of Acoustic Based Partial Discharge Détection Using Pattern Récognition Techniques,* 2011